# DEMANDE DE BREVET EUROPEEN

(11) **EP 4 711 774 A1**
(43) Date de publication de la demande: **18.03.2026**
(21) Numéro de dépôt: 25199037.0
(22) Date de dépôt: 29.08.2025
(51) Int. Cl.: G01R 19/00, G01R 31/40, H02M 1/00

(54) **CIRCUIT DE DETECTION DE COURANT**

(30) Priorité: 13.09.2024 FR 2409737
(71) Demandeur: STMicroelectronics International N.V., 1228 Plan-les-Ouates, Geneva (CH)
(72) Inventeur: LECONTE, Bruno, 13790 Rousset (FR)
(74) Mandataire: Cabinet Beaumont

(57) **Abrégé**

La présente description concerne un circuit de détection (150) d'un courant de sortie d'une alimentation à découpage (100) comprenant un montage échantillonneur bloqueur (SnH151) adapté à stocker une image dudit courant de sortie pendant une phase de non conduction d'un interrupteur haute tension (M101) de ladite alimentation à découpage (100).

## Description

### Domaine technique

La présente description concerne de façon générale les systèmes et circuits électroniques, et plus particulièrement des systèmes et circuits électroniques adaptés à fournir une alimentation électrique. La présente description se rapporte plus précisément à une alimentation à découpage et à un circuit permettant de fournir une image d'un courant de sortie d'une alimentation à découpage.

### Technique antérieure

Il existe plusieurs types de circuits d'alimentation électrique permettant de délivrer un couple courant/tension à un circuit, ou dispositif ou système électronique, ou plus généralement à une charge. Les alimentations linéaires et les alimentations à découpage sont des exemples de circuits d'alimentation.

Une alimentation à découpage (Switched Mode Power Supply, ou SMPS) est un circuit d'alimentation adapté à fournir une tension continue à partir d'une tension d'entrée. Les alimentations à découpage sont généralement des convertisseurs DC/DC, prenant en entrée une tension continue, mais certaines alimentations à découpage peuvent comprendre un étage de redressement leur permettant de prendre en entrée une tension alternative, par exemple, le secteur.

Une alimentation à découpage est souvent équipée d'un ou plusieurs circuits permettant de mesurer le courant et/ou la tension qu'elle fournit. Ces circuits ont, par exemple, pour but de vérifier le bon fonctionnement de l'alimentation à découpage.

Il serait souhaitable de pouvoir améliorer, au moins en partie, certains aspects des alimentations à découpage connues, et, en particulier, certains aspects des circuits de détection de courant d'alimentation à découpage.

### Résumé de l'invention

Il existe un besoin pour des alimentations à découpage plus performantes.

Il existe un besoin pour des alimentations à découpage comprenant des circuits de détection de courant plus performants.

Un mode de réalisation pallie tout ou partie des inconvénients des alimentation à découpage connues.

Un mode de réalisation pallie tout ou partie des inconvénients des circuits de détection de courant d'alimentation à découpage connus.

Un mode de réalisation prévoit un circuit de détection de courant adapté à mesurer un courant de sortie d'une alimentation à découpage.

Un mode de réalisation prévoit un circuit de détection de courant comprenant un circuit d'échantillonnage.

Un mode de réalisation prévoit un circuit de détection d'un courant de sortie d'une alimentation à découpage comprenant un montage échantillonneur bloqueur adapté à stocker une image dudit courant de sortie pendant une phase de non conduction d'un interrupteur haute tension de ladite alimentation à découpage.

Un autre mode de réalisation prévoit un procédé de détection de courant utilisant un circuit de détection d'un courant de sortie d'une alimentation à découpage comprenant un montage échantillonneur bloqueur adapté à stocker une image dudit courant de sortie pendant une phase de non conduction d'un interrupteur haute tension de ladite alimentation à découpage.

Selon un mode de réalisation, ladite image est une image du courant dans les ledit interrupteur.

Selon un mode de réalisation, un résultat fourni par ledit montage est comparé à un seuil, de sorte à fournir une information sur un dépassement du seuil.

Selon un mode de réalisation, ledit seuil est fourni par un courant de référence produit par un convertisseur numérique-analogique.

Selon un mode de réalisation, ledit montage échantillonneur bloqueur comprend un interrupteur et un condensateur.

Selon un mode de réalisation, ledit montage échantillonneur bloqueur est adapté à être commandé par un signal d'échantillonnage.

Selon un mode de réalisation, ledit signal d'échantillonnage déclenche le stockage de ladite image dudit premier courant avec un retard temporel.

Selon un mode de réalisation, ledit montage échantillonneur bloqueur est adapté à recevoir directement ledit courant de sortie.

Selon un mode de réalisation, ledit circuit comprend :
- une boucle d'asservissement adaptée à recevoir un premier courant à détecter ; et
- un premier transistor et un deuxième transistors montés en miroir de courant, ledit premier transistor étant adapté à recevoir une sortie de ladite boucle d'asservissement, et ledit deuxième transistor étant adapté à fournir ladite image dudit courant de sortie,
ledit montage échantillonneur bloqueur étant disposé entre les bornes de commande des premier et deuxième transistors.

Selon un mode de réalisation, ladite boucle d'asservissement comprend un comparateur de courant adapté à recevoir une image dudit courant de sortie.

Selon un mode de réalisation, ledit deuxième transistor est adapté à recevoir, en outre, ledit courant de référence.

Selon un mode de réalisation, ledit deuxième courant de référence est adapté à être fourni par un convertisseur numérique analogique.

Un autre mode de réalisation prévoit une alimentation à découpage comprenant un circuit de détection de courant décrit précédemment.

Selon un mode de réalisation, l'alimentation à découpage est une alimentation à découpage de type buck, une alimentation à découpage de type boost, ou une alimentation à découpage de type buck-boost.

Un autre mode de réalisation prévoit un dispositif comprenant une alimentation à découpage décrite précédemment.

Selon un mode de réalisation, le dispositif est un microcontrôleur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente une partie d'une alimentation à découpage comprenant un circuit de détection de courant selon un mode de réalisation ;
la figure 2 représente un mode de réalisation d'un circuit de détection de courant ;
la figure 3 représente des graphiques illustrant le fonctionnement du mode de réalisation de la figure 2 ;
la figure 4 représente d'autres graphiques illustrant le fonctionnement du mode de réalisation de la figure 2 ;
la figure 5 représente plus en détails une partie du mode de réalisation de la figure 1 ;
la figure 6 représente plus en détails une partie du mode de réalisation de la figure 1 ;
la figure 7 représente plus en détails une partie du mode de réalisation de la figure 2 ;
la figure 8 représente plus en détails une partie du mode de réalisation de la figure 2 ;
la figure 9 représente plus en détails une partie du mode de réalisation de la figure 2 ;
la figure 10 représente plus en détails une partie du mode de réalisation de la figure 2 ; et
la figure 11 représente une application des modes de réalisation décrits.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

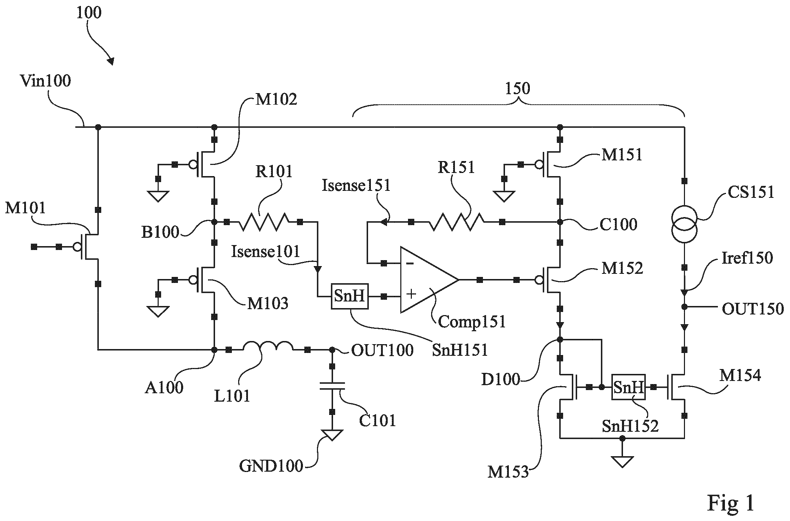

Les modes de réalisation décrits ci-après concernent la mise en œuvre d'une alimentation à découpage, et plus particulièrement la mise en œuvre d'une détection d'un courant de sortie de cette alimentation à découpage par un circuit de détection de courant. Les inventeurs ont observé que la détection d'un dépassement d'un courant seuil par un courant de sortie d'une alimentation à découpage peut subir un retard dans certains cas. La présente description se propose donc de pallier ce problème en ajoutant un échantillonneur bloqueur (Sample and Hold (SnH)) au circuit de détection de courant. Cela est décrit en relation avec les figures 1 à 10.

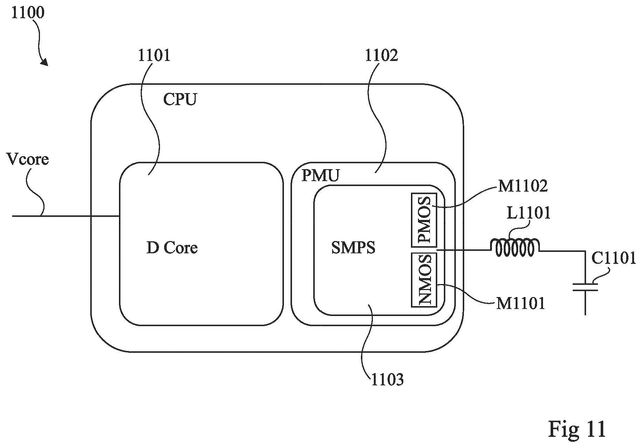

De plus, les modes de réalisation décrits ci-après sont tout particulièrement adaptés à être utilisé dans un microcontrôleur générique de petits ou gros électroménagers, de cigarettes électroniques, de périphériques d'ordinateur, de téléphones mobiles, etc. Une application de ces modes de réalisation est décrite plus en détail en relation avec la figure 11.

De plus, les modes de réalisation décrits ci-dessus sont particulièrement adaptés pour être utilisés dans tout type de marchés industriels où une alimentation à découpage est nécessaire. Plus particulièrement, une telle alimentation à découpage peut être destiné à :
- l'industrie automobile, par exemple dans le domaine de l'électrification automobile ou dans le domaine des systèmes avancés d'aide à la conduite (Advanced Driver Assistance Systems - ADAS) ;
- le domaine industriel, par exemple dans le domaine de l'énergie verte, dans le domaine de l'électrification des infrastructures, de l'internet des objets (Internet of Things
- IoT) et des maisons intelligentes (SmartHome), où la consommation d'électricité et d'énergie et l'échange de données sont des éléments clés ;
- l'industrie de l'électronique personnelle, par exemple dans le domaine de la téléphonie mobile et de l'internet des objets (Internet of Things - IoT), ainsi que dans le domaine des interfaces haut débit ; et
- l'industrie des équipements de communication, des ordinateurs et des périphériques, par exemple dans le domaine des infrastructures et des centres de données (Data Centers), et dans le domaine des satellites en orbite terrestre basse (Low Earth Orbit - LEO).

Une alimentation à découpage (ou convertisseur à découpage) comporte généralement deux interrupteurs de découpage d'une tension continue à convertir en série entre deux bornes d'application de cette tension à convertir. Le point milieu entre ces interrupteurs de découpage est reliée, par un circuit inductif (bobine ou autre), à une borne de fourniture d'une tension continue, lissée par un élément capacitif entre cette borne de fourniture et une borne de référence de tension (par exemple la borne de référence de la tension à convertir). On désigne généralement par interrupteur côté haut (high-side) l'interrupteur de découpage reliant la borne d'application de du potentiel supérieur de la tension à convertir au point milieu relié au circuit inductif et interrupteur côté bas (low-side), l'interrupteur de découpage reliant ce point milieu au potentiel inférieur (borne de référence) de la tension à convertir. L'interrupteur côté haut est commandé par un signal de découpage. L'interrupteur côté bas peut être un interrupteur commandable (à borne de commande) ou automatique (de type diode). Les interrupteurs de découpage à semiconducteur sont généralement des transistors MOS de puissance, respectivement à canal P côté haut et à canal N côté bas. Le cas échéant (selon la nature du convertisseur), l'interrupteur côté bas est une diode (dite de roue libre).

La figure 1 représente une partie d'une alimentation à découpage 100 comprenant un circuit de détection de courant 150 selon un mode de réalisation.

La partie 100 comprend, en outre, un interrupteur haute tension M101, c'est-à-dire un interrupteur adapté à recevoir, sur une de ses bornes de conduction, une tension à convertir Vin100 (en étant reliée à une première borne d'application du potentiel haut de cette tension) et à fournir une tension convertie à une sortie de l'alimentation à découpage via une bobine L101. Une deuxième borne de l'interrupteur M101 est reliée, de préférence connectée, à un nœud A100 reliée à la bobine L101. La borne de commande de l'interrupteur M101 est adaptée à recevoir une tension de commande de l'alimentation à découpage.

L'interrupteur de découpage M101 est l'interrupteur côté haut de l'alimentation à découpage. Le nœud A100 est donc relié, par un interrupteur côté bas (non représenté), à l'autre borne d'application de la tension Vin100.

Selon un mode de réalisation, l'interrupteur haute tension M101 est un transistor à effet de champ à grille métal-oxyde (metal-oxide-semiconductor field-effect transistor), ou transistor MOSFET, ou transistor MOS. De plus, l'interrupteur M101 est un transistor MOS à canal P, ou transistor MOS de type P, ou transistor PMOS.

De façon similaire, une alimentation à découpage comprend, en outre, typiquement un interrupteur côté bas (non représenté en figure 1), c'est-à-dire un interrupteur adapté à relier le nœud A100 à une deuxième borne d'application de la tension Vin100, par exemple une tension de référence GND100, par exemple la masse.

Le fonctionnement d'une alimentation à découpage est basé sur une succession de phases de conduction et de non conduction alternées de l'interrupteur haut (côté haute tension) et de l'interrupteur bas (côté basse tension). Ce fonctionnement est classique et à la portée de la personne du métier.

La partie 100 comprend, en outre, deux interrupteurs M102 et M103 disposés en série entre eux et formant un montage parallèle à l'interrupteur M101. Selon un exemple, les interrupteurs M102 et M103 sont tous deux des interrupteurs du même type que l'interrupteur M101, c'est-à-dire, dans le cas illustré en figure 1, des transistors de type PMOS. Ainsi, une première borne de conduction de l'interrupteur M102 est reliée, de préférence connectée, au nœud fournissant la tension à convertir Vin100, et une deuxième borne de conduction de l'interrupteur M102 est reliée, de préférence connectée, à une première borne de conduction de l'interrupteur M103 et à un nœud B100. Une deuxième borne de conduction de l'interrupteur M103 est reliée, de préférence connectée, au nœud A100. Les bornes de commande des interrupteurs M102 et M103 sont adaptées à recevoir des tensions de commande du même type que la tension de commande reçue par la borne de commande de l'interrupteur M101.

Le nœud B100 est un nœud fournissant une image du courant de sortie de l'alimentation à découpage, et c'est cette image du courant que le circuit de détection de courant 150 se propose d'évaluer.

Selon un exemple, le circuit inductif (bobine L101) et un élément capacitif de lissage forment un circuit de filtrage. La partie 100 comprend alors, en outre, un tel circuit de filtrage de type LC comprenant la bobine L101 et un condensateur C101. Ce circuit de filtrage est disposé entre le nœud A100 et un nœud fournissant la tension de référence GND100. Plus particulièrement, une première borne de la bobine L101 est reliée, de préférence connectée, au nœud A100, et une deuxième borne de la bobine L101 est reliée, de préférence connectée, à une première borne du condensateur C101 noté nœud OUT100. Une deuxième borne du condensateur C101 est reliée, de préférence connectée, au nœud fournissant la tension de référence GND100. Le nœud OUT100 est le nœud de sortie de l'alimentation à découpage et permet de fournir une tension de sortie de l'alimentation à découpage.

Comme dit précédemment, la partie 100 est équipée d'un circuit de détection de courant 150 adapté à détecter et évaluer un courant de sortie de l'alimentation à découpage, et, plus particulièrement, une image Isense101 de ce courant de sortie fournie par le nœud B100.

Selon un exemple, le circuit 150 comprend une boucle d'asservissement adapté à recevoir le courant Isense101 à mesurer. Cette boucle d'asservissement comporte, par exemple, un circuit comparateur Comp151, deux transistors M151 et M152 et une résistance R151. Une entrée non inverseuse (+) du circuit comparateur Comp151, ou comparateur Comp151, est adaptée à recevoir le courant à mesurer Isense101, par exemple, par l'intermédiaire d'une résistance R101 de la partie 100. Une entrée inverseuse (-) du circuit comparateur Comp151 est reliée, de préférence connectée, à une première borne de la résistance R151. Une deuxième borne de la résistance R151 est reliée, de préférence connectée, à un nœud C100. Les transistors M151 et M152 sont, par exemple, des transistors de type PMOS. Une première borne de conduction du transistor M151 est reliée, de préférence connectée, au nœud fournissant la tension Vin100, et une deuxième borne de conduction du transistor M151 est reliée, de préférence connectée, au nœud C100. Une borne de commande du transistor M151 est adapté à recevoir une tension de commande. Une première borne de conduction du transistor M152 est reliée, de préférence connectée, au nœud C100, et une deuxième borne de conduction du transistor M151 est reliée, de préférence connectée, à un nœud D100. Une borne de commande du transistor M152 est reliée, de préférence connectée, au nœud de sortie du circuit comparateur Comp151.

Selon un exemple, le circuit 150 comprend, en outre, un montage miroir de courant, ou circuit miroir de courant, ou simplement miroir de courant. Ce montage comporte deux transistors M153 et M154, qui sont, par exemple, des transistors MOS à canal N, ou transistors MOS de type N, ou transistors NMOS. Une première borne de conduction du transistor M153 est reliée, de préférence connectée, au nœud D100, et une deuxième borne de conduction du transistor M153 est reliée, de préférence connectée, au nœud fournissant la tension de référence GND100. Une première borne de conduction du transistor M154 est reliée, de préférence connectée, à un nœud de sortie OUT150 du circuit 150, et une deuxième borne de conduction du transistor M154 est reliée, de préférence connectée, au nœud fournissant la tension de référence GND100. Les bornes de commande des transistors M153 et M154 sont reliées entre elles et au nœud D100.

Selon un exemple, le circuit 150 comprend, en outre, une source de courant CS151 adapté à fournir un courant qui ne dépend pas de la température. La source de courant CS151 est, par exemple, adaptée à fournir un courant de référence Iref150 au nœud de sortie OUT150. Selon un exemple, la source de courant CS151 est alimentée par la tension Vin100. Selon un exemple, la source de courant peut être mise en œuvre en partie par un convertisseur numérique analogique.

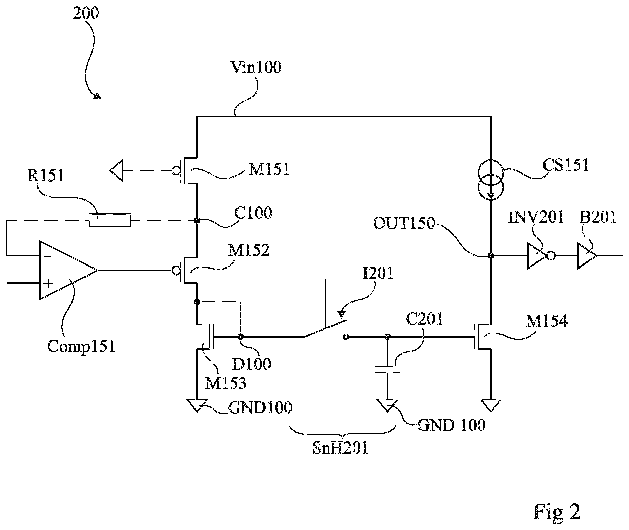

Selon un mode de réalisation, le circuit 150 comprend, en outre, un circuit échantillonneur bloqueur. Ce circuit permet de stocker la valeur mesurée du courant Isense101 par le circuit 150 pendant une phase de non conduction de l'interrupteur M101. En effet, le circuit 150 est disposé en sortie de l'interrupteur M101 et ne peut mesurer le courant Isense101 que lors d'une phase de conduction de l'interrupteur M101, et des interrupteurs M102 et M103. Un exemple de circuit échantillonneur bloqueur est décrit en détail en relation avec la figure 2. Deux placements possibles du circuit échantillonneur bloqueur sont illustrés en figure 1.

Selon un premier mode de réalisation, illustré par le circuit échantillonneur bloqueur SnH151 (SnH) en figure 1, le circuit SnH151 est disposé en entrée du circuit 150. Plus particulièrement, le circuit SnH151 est disposé en entrée de la boucle d'asservissement, c'est-à-dire par exemple en entrée du circuit comparateur Comp151. Selon un exemple, une borne d'entrée du circuit SnH151 est reliée, de préférence connectée, au nœud B100, ou à une borne de connexion de la résistance R101, et une borne de sortie du circuit SnH151 est reliée, de préférence connectée, à la borne d'entrée inverseuse du circuit comparateur Comp151.

Selon un deuxième mode de réalisation, illustré par le circuit échantillonneur bloqueur SnH152 (SnH) en figure 1, le circuit SnH152 est disposé au niveau du montage en miroir de courant. Plus particulièrement, le circuit SnH152 est positionné entre les bornes de commande des transistors 153 et M154. Selon un exemple, une borne d'entrée du circuit SnH152 est reliée, de préférence connectée, à la borne de commande du transistor M153, et une borne de sortie du circuit SnH151 est reliée, de préférence connectée, à la borne de commande du transistor M154.

Selon un troisième mode de réalisation, non illustré en figure 1, le circuit échantillonneur bloqueur peut être disposé en amont du montage miroir de courant, par exemple en étant au sein d'un autre montage miroir de courant disposé en amont de celui formé par les transistors M153 et M154.

Selon un mode de réalisation, un procédé d'utilisation du circuit 150 est le suivant. Le circuit échantillonneur bloqueur est activé pour stocker la valeur du courant à mesurer au début d'une phase de non conduction de l'interrupteur M101. Selon un exemple, le circuit échantillonneur bloqueur est activé par un signal d'échantillonnage, aussi appelé signal de commande. Selon un exemple, le circuit échantillonneur bloqueur peut ne pas être activé directement au début d'une phase de non conduction mais peut laisser un délai pour laisser le courant se stabiliser.

Dans les modes de réalisation décrits, le courant n'a besoin d'être mesuré que du côté haut (high-side) du convertisseur. Le circuit 150 n'a donc pas besoin d'être dupliqué côté bas (côté transistor low-side).

Par ailleurs, l'utilisation d'un circuit d'échantillonnage permet de conserver une image du courant du convertisseur même pendant les périodes où le transistor haut M101 est ouvert (off). Cela permet d'effectuer une comparaison précise entre le courant de référence Iref150 et le courant mesuré du convertisseur (courant dans le transistor M154) sans avoir besoin d'être rapide (une réponse de l'ordre de la microseconde suffit). Le comparateur peut alors être de constitution simple. Typiquement, le comparateur peut être constitué de deux miroirs de courant, d'où une faible consommation et une faible surface de silicium, ce qui participe à réduire les coûts de production du circuit intégrant le convertisseur. Sans circuit d'échantillonnage, il aurait fallu un comparateur rapide (de l'ordre de 100 ns avec des fréquences de découpage de plusieurs centaines de kHz/Mhz) pour obtenir une comparaison pendant les périodes où le transistor haut est passant (on).

La figure 2 représente un circuit de détection de courant 200 du type du circuit 150 décrit en relation avec la figure 1. Plus particulièrement, la figure 2 illustre un exemple de réalisation du premier mode de réalisation décrit en relation avec la figure 1.

Le circuit 200 comprend les mêmes composants que le circuit 150. Dit autrement, le circuit 200 comprend :
- la boucle d'asservissement comprenant le circuit comparateur Comp151, la résistance R151 et les transistors M151 et M152 ; et
- le montage en miroir de courant comprenant les transistors M153 et M154.

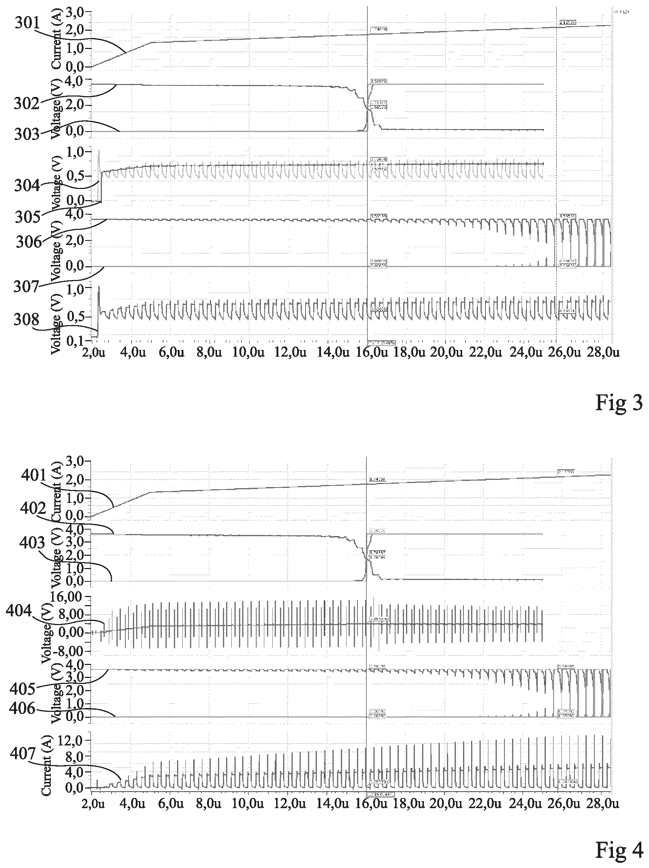

Selon un mode de réalisation, le circuit 200 comprend, en outre, un circuit échantillonneur bloqueur SnH201 disposé comme le circuit SnH152 décrit en relation avec la figure 1. Le circuit SnH201 comprend, selon un mode de réalisation, un interrupteur I201 et un condensateur C201. Une première borne de conduction de l'interrupteur I201 est reliée, de préférence connectée, à la première borne de conduction du transistor M153 et à la borne de commande de ce même transistor, et une deuxième borne de conduction de l'interrupteur I201 est reliée, de préférence connectée, à la borne de commande du transistor M154. Une borne de commande de l'interrupteur I201 est adaptée à recevoir une tension de commande. Une telle tension de commande est détaillée en relation avec les figures 3 et 4. Une première borne du condensateur C201 est reliée, de préférence connectée, à la borne de commande du transistor M154, et une deuxième borne du condensateur C201 est reliée, de préférence connectée, au nœud fournissant la tension de référence GND100.

Selon un exemple, le circuit 200 comprend, en outre, un circuit inverseur INV201 et un circuit tampon B201. Selon un exemple, une borne d'entrée du circuit inverseur INV201 est reliée, de préférence connectée, au nœud OUT150, et une borne de sortie du circuit inverseur INV201 est reliée, de préférence connectée, à une borne d'entrée du circuit tampon B201. Une borne de sortie du circuit tampon B201 forme une borne de sortie du circuit 200.

Les figures 3 et 4 sont des graphiques illustrant le fonctionnement du circuit 200 décrit en relation avec la figure 2.

La figure 3 comprend les graphiques suivants :
- une courbe 301 illustrant l'évolution d'un courant de sortie de l'alimentation à découpage ;
- une courbe 302 illustrant l'évolution de la tension de sortie du circuit 200 au niveau du nœud OUT150 ;
- une courbe 303 illustrant l'évolution de la tension de sortie du circuit 200 au niveau de la sortie du circuit tampon B201 ;
- une courbe 304 illustrant l'évolution de la tension grille source du transistor M153 qui est une image du courant à mesurer ;
- une courbe 305 illustrant l'évolution de la tension grille source du transistor M154 qui est une image du courant à mesurer ;
- une courbe 306 illustrant l'évolution de la tension de sortie d'un circuit du type du circuit 200 mais ne comprenant pas de circuit échantillonneur bloqueur, au niveau du nœud OUT150 ;
- une courbe 307 illustrant l'évolution de la tension de sortie d'un circuit du type du circuit 200 mais ne comprenant pas de circuit échantillonneur bloqueur, au niveau de la sortie du circuit tampon B201 ; et
- une courbe 308 illustrant l'évolution de l'image du courant au niveau de la borne de commande du transistor M154 d'un circuit du type du circuit 200 mais ne comprenant pas de circuit échantillonneur bloqueur.

La figure 4 comprend les graphiques suivants :
- une courbe 401 illustrant l'évolution d'un courant de sortie de l'alimentation à découpage ;
- une courbe 402 illustrant l'évolution de la tension de sortie du circuit 200 au niveau du nœud OUT150 ;
- une courbe 403 illustrant l'évolution de la tension de sortie du circuit 200 au niveau de la sortie du circuit tampon B201 ;
- une courbe 404 illustrant l'évolution du courant drain source du transistor M154 ;
- une courbe 405 illustrant l'évolution de la tension de sortie d'un circuit du type du circuit 200 mais ne comprenant pas de circuit échantillonneur bloqueur, au niveau du nœud OUT150 ;
- une courbe 406 illustrant l'évolution de la tension de sortie d'un circuit du type du circuit 200 mais ne comprenant pas de circuit échantillonneur bloqueur, au niveau de la sortie du circuit tampon B201 ; et
- une courbe 407 illustrant l'évolution du courant drain source du transistor M154 d'un circuit du type du circuit 200 mais ne comprenant pas de circuit échantillonneur bloqueur.

Ces courbes permettent de montrer que l'utilisation d'un circuit échantillonneur permet de détecter plus rapidement un dépassement d'un seuil par le courant de sortie de l'alimentation à découpage.

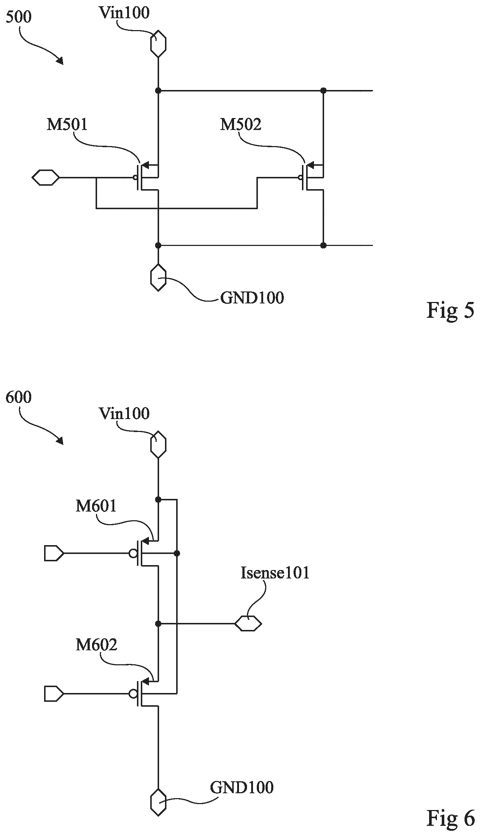

La figure 5 représente un exemple pratique de réalisation d'une portion de la partie 100 décrite en relation avec la figure 1. Plus particulièrement, la figure 5 illustre un exemple pratique 500 de réalisation de l'interrupteur M101 décrit en relation avec la figure 1.

Selon un exemple, l'interrupteur 500 comporte deux transistors M501 et M502, par exemple, des transistors de type PMOS, disposés en parallèle.

Plus particulièrement, selon un exemple, une borne de source du transistor M501 est reliée, de préférence connectée, à une borne fournissant la tension Vin100, et une borne de drain du transistor M501 est reliée, de préférence connectée, à une borne fournissant la tension de référence GND100. Selon un exemple, une borne de source du transistor M502 est reliée, de préférence connectée, à une borne fournissant la tension Vin100, et une borne de drain du transistor M502 est reliée, de préférence connectée, à une borne fournissant la tension de référence GND100. Les bornes de grilles des transistors M501 et M5002 sont reliées entre elles et à un nœud fournissant une tension de commande définissant les phases de conduction et de non conduction des transistors M501 et M502.

La figure 6 représente un exemple pratique de réalisation d'une portion de la partie 100 décrite en relation avec la figure 1. Plus particulièrement, la figure 6 illustre un exemple pratique 600 de réalisation des interrupteurs M102 et M103 décrits en relation avec la figure 1.

Selon un exemple, le circuit 600 comporte deux transistors M601 et M602, par exemple, des transistors de type PMOS, disposés en série.

Plus particulièrement, selon un exemple, une borne de source du transistor M601 est reliée, de préférence connectée, à une borne fournissant la tension Vin100, et une borne de drain du transistor M601 est reliée, de préférence connectée, à une borne de source du transistor M602, et fournit le courant Isense101. Selon un exemple, une borne de drain du transistor M602 est reliée, de préférence connectée, au nœud fournissait la tension de référence GND100.

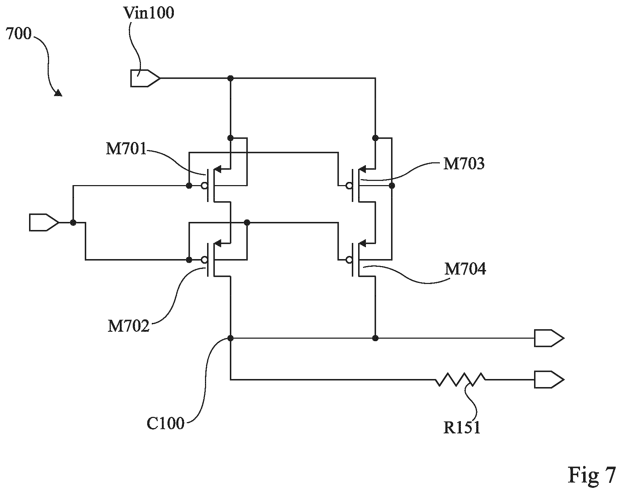

La figure 7 représente un exemple pratique de réalisation d'une portion du circuit 150 décrit en relation avec la figure 1. Plus particulièrement, la figure 7 illustre un exemple pratique 700 de réalisation du transistor M151 décrit en relation avec la figure 1.

Selon un exemple, le circuit 700 comporte quatre transistors M701, M702, M703 et M704, par exemple, des transistors de type PMOS, montés en pont. La résistance R151 est également représentée en figure 7.

Plus particulièrement, selon un exemple, une borne de source du transistor M701 est reliée, de préférence connectée, à une borne fournissant la tension Vin100, et une borne de drain du transistor M701 est reliée, de préférence connectée, à une borne de source du transistor M702. Selon un exemple, une borne de drain du transistor M702 est reliée, de préférence connectée, au nœud C100 et à une première borne de la résistance R151. Selon un exemple, une borne de source du transistor M703 est reliée, de préférence connectée, à une borne fournissant la tension Vin100, et une borne de drain du transistor M703 est reliée, de préférence connectée, à une borne de source du transistor M704. Selon un exemple, une borne de drain du transistor M704 est reliée, de préférence connectée, au nœud C100 et à une première borne de la résistance R151. Toutes les bornes de grilles des transistors M701, M702, M703 et M704 sont reliées entre elles et à un nœud fournissant une tension de commande.

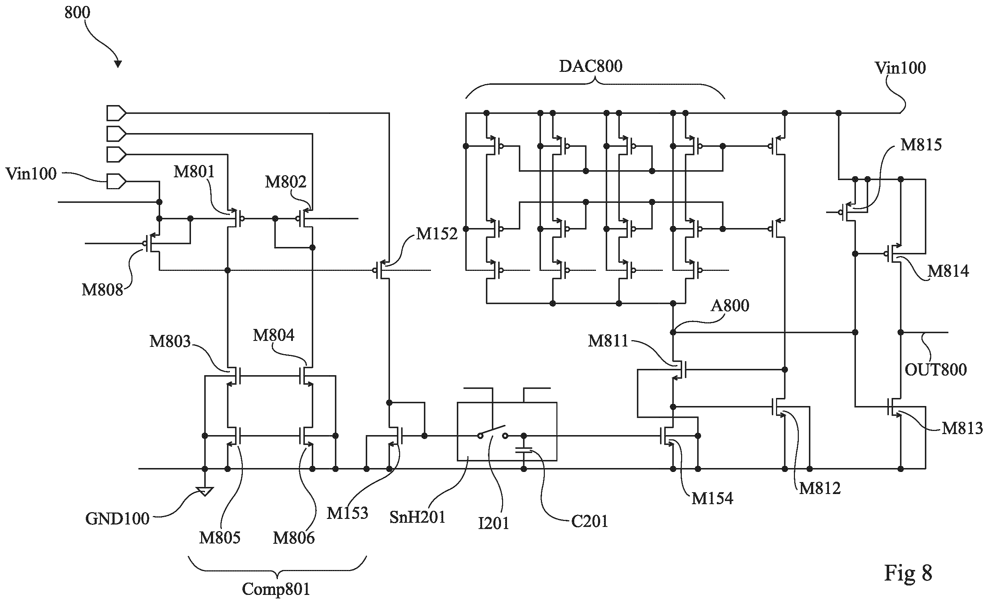

La figure 8 représente un exemple pratique de réalisation d'une portion du circuit 150 décrit en relation avec la figure 1. Plus particulièrement, la figure 8 illustre un exemple pratique 800 de réalisation du comparateur Comp151, le montage miroir de courant, le circuit échantillonneur bloqueur SnH152 et la source de courant CS151 décrits en relation avec la figure 1.

Selon un exemple, le circuit 800 comprend :
- un comparateur Comp801 qui est un exemple pratique du comparateur Comp151 ; et
- une source de courant.

Selon un exemple, le comparateur Comp801 comprend sept transistors M801, M802, M803, M804, M805, M806, et M808. Les transistors M801, M802 et M808 sont, par exemple, des transistors de type PMOS. Les transistors M803 à M807 sont, par exemple, des transistors de type NMOS.

Les transistors M801 et M802 sont montés en miroir de courant. Selon un exemple, la borne de source du transistor M801 forme la borne inverseuse du comparateur Comp801, et la borne de drain du transistor M801 est reliée, de préférence connectée, à une borne formant la borne de sortie du comparateur Comp801 et donc est reliée, de préférence connectée, à la borne de grille du transistor M152. Selon un exemple, la borne de source du transistor M802 forme la borne non inverseuse du comparateur Comp801, et la borne de drain du transistor M802 est reliée, de préférence connectée, à la borne formant la borne de sortie du comparateur Comp801 et donc est reliée, de préférence connectée, à la borne de grille du transistor M152. Les bornes de grilles des transistors M801 et M802 sont reliées entre elles et à la borne de drain du transistor M802.

Selon un exemple, les transistors M803, M804, M805, et M806 sont montés en pont. Plus particulièrement, selon un exemple, une borne de drain du transistor M803 est reliée, de préférence connectée, à la borne de source du transistor M801, et une borne de source du transistor M803 est reliée, de préférence connectée, à une borne de drain du transistor M805. Selon un exemple, une borne de source du transistor M805 est reliée, de préférence connectée, au nœud fournissant la tension de référence GND100. Selon un exemple, une borne de drain du transistor M804 est reliée, de préférence connectée, à la borne de source du transistor M802, et une borne de source du transistor M804 est reliée, de préférence connectée, à une borne de drain du transistor M806. Selon un exemple, une borne de source du transistor M806 est reliée, de préférence connectée, au nœud fournissant la tension de référence GND100. Selon un exemple, les bornes de grilles des transistors M803 et M804 sont reliées entre elles et à un nœud fournissant une tension de commande. Les transistors M803 et M804 sont montés en cascode et permettent de limiter la tension de drain de transistors M805 et M806. Selon un exemple, les bornes de grilles des transistors M805 et M806 sont reliées entre elles et à un nœud fournissant une tension de commande. Les transistors M805 et M806 servent de source de courant et polarisent la structure formée par le circuit 800.

Selon un exemple, une borne de source du transistor M808 est reliée, de préférence connectée, à une borne recevant la tension Vin100, et une borne de drain du transistor M808 est reliée, de préférence connectée, à la borne de drain du transistor M801.

Les transistors M153 et M154 sont représentés en figure 8, ainsi que le circuit échantillonneur bloqueur NH201 décrit en relation avec la figure 2.

Selon un exemple, le source de courant comprend un convertisseur numérique analogique DAC800 comportant plusieurs transistors de type PMOS disposés en matrice selon un montage connu de la personne du métier. Dans l'exemple représenté, le convertisseur DAC800 comporte quatre branches identiques (convertisseur 4 bits) en parallèle entre le nœud d'application de la tension Vin100 (nœud haut) et le drain (nœud A800) d'un transistor M811, par exemple de type NMOS, monté en cascode avec le transistor M154. Selon un exemple, une borne de source du transistor M811 est reliée, de préférence connectée, à la borne de source du transistor M154. Une borne de grille du transistor M811 reçoit une tension de cascode d'un transistor M812, par exemple de type NMOS. Selon un exemple, une borne de source du transistor M812 est reliée, de préférence connectée au nœud recevant la tension de référence GND100. Une borne de grille du transistor M812 est reliée, de préférence connectée, à la borne de source du transistor M811 (drain du transistor M154). Le transistor M812 est polarisé en étant relié, au nœud d'application du potentiel haut de la tension Vin100, par deux transistors MOS à canal P montés en miroir sur les transistors constituent les sources de courant du convertisseur.

La nœud A800 fournit le résultat de la conversion numérique-analogique produisant le courant de référence Iref150 à partir d'une consigne numérique (dans cet exemple sur 4 bits). Ce nœud A800 correspond, par exemple, au nœud OUT150 de la figure 1.

La comparaison entre le courant de référence et la courant du convertisseur (dont le courant traversant le transistor M154 est une image) est effectuée par un étage constitué de transistors M813, M814 et M815 fournissant sur un nœud OUT800, une information numérique (digitale) sur le fait que le courant de référence est supérieur ou inférieur au courant du convertisseur. Selon un exemple, le transistors M813 est de type NMOS. Selon un exemple, une borne de source du transistor M813 est reliée, de préférence connectée au nœud recevant la tension de référence GND100, et une borne de drain du transistor M813 est reliée, de préférence connectée, au nœud de sortie OUT800. Une borne de grille du transistor M813 est reliée, de préférence connectée, au nœud A800.

Selon un exemple, le transistors M814 est de type PMOS. Selon un exemple, une borne de source du transistor M814 est reliée, de préférence connectée au nœud fournissant la tension Vin100 (potentiel haut), et une borne de drain du transistor M814 est reliée, de préférence connectée, au nœud de sortie OUT800. Une borne de grille du transistor M814 est reliée, de préférence connectée, au nœud A800.

Selon un exemple, le transistors M815 est de type PMOS. Selon un exemple, une borne de source du transistor M815 est reliée, de préférence connectée au nœud fournissant la tension Vin100, et une borne de drain du transistor M814 est reliée, de préférence connectée, au nœud A800. Le transistor M815 permet d'éviter que le nœud A800 soit flottant lorsque le circuit 800 est éteint.

Le fait d'utiliser un convertisseur numérique-analogique facilite le réglage du courant de référence, donc du seuil de détection.

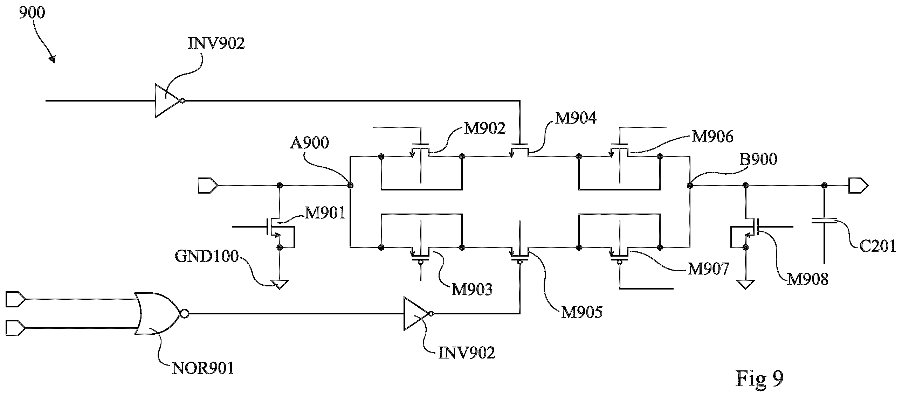

La figure 9 représente un exemple pratique de réalisation d'une portion du circuit 200 décrit en relation avec la figure 2. Plus particulièrement, la figure 9 illustre un exemple pratique 900 de réalisation de l'interrupteur I201 décrit en relation avec la figure 2.

Selon un exemple, le circuit 900 comporte des transistors M901, M902, M903, M904, M905, M906, M907 et M908 montés en pont, deux inverseurs et une porte logique de type NON-OU (NOR). La résistance R151 est également représentée en figure 7. Les transistor M901, M902, M904, M906 et LM908 sont de type NMOS. Les transistor M903, M905, et LM907 sont de type PMOS.

Selon un exemple, une borne de drain du transistor M901 est reliée, de préférence connectée, à une borne d'entrée du circuit 900, notée A900, et une borne de source du transistor M901 est reliée, de préférence connectée, au nœud recevant la tension de référence GND100.

Selon un exemple, une borne de source du transistor M902 est reliée, de préférence connectée, à sa borne de drain et au nœud A900. Une borne de grille du transistor M902 reçoit une tension de commande. Selon un exemple, une borne de source du transistor M904 est reliée, de préférence connectée, à sa borne de drain. Une borne de grille du transistor M904 reçoit une tension de commande. Selon un exemple, une borne de source du transistor M906 est reliée, de préférence connectée, à sa borne de drain et à la borne de sortie du circuit 900 notée nœud B900. Une borne de grille du transistor M906 reçoit une tension de commande.

Selon un exemple, une borne de source du transistor M903 est reliée, de préférence connectée, à sa borne de drain et au nœud A900. Une borne de grille du transistor M903 reçoit une tension de commande. Selon un exemple, une borne de source du transistor M905 est reliée, de préférence connectée, à sa borne de drain. Une borne de grille du transistor M905 reçoit une tension de commande. Selon un exemple, une borne de source du transistor M907 est reliée, de préférence connectée, à sa borne de drain et à la borne de sorite du circuit 900 notée nœud B900. Une borne de grille du transistor M907 reçoit une tension de commande.

Selon un exemple, une borne de drain du transistor M908 est reliée, de préférence connectée, au nœud B900, et une borne de source du transistor M908 est reliée, de préférence connectée, au nœud recevant la tension de référence GND100.

Une borne d'entrée de l'inverseur INV902 reçoit une tension de commande et une borne de sortie de l'inverseur INV902 est reliée, de préférence connectée, à la borne de grille du transistor M904.

Les bornes d'entrée de la porte NOR901 reçoivent des tensions de commande. La borne de sortie de la porte NOR901 est reliée, de préférence connectée à l'entrée de l'inverseur INV902. Une borne de sortie de l'inverseur INV902 est reliée, de préférence connectée, à la borne de grille du transistor M905.

La figure 9 représente, en outre, le condensateur C201.

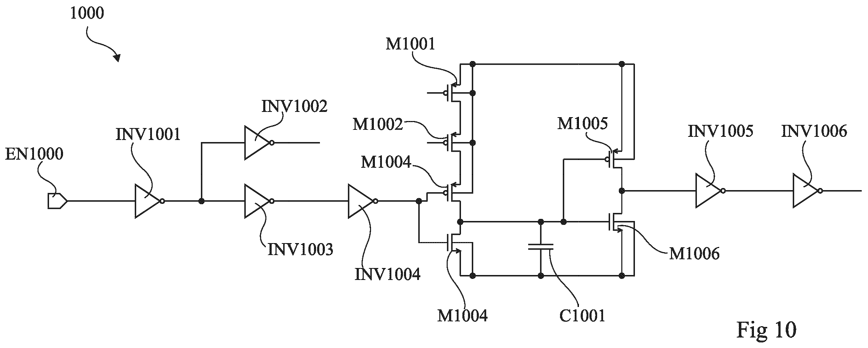

La figure 10 représente un exemple de circuit à retard 1000 pouvant appliquer un retard d'activation du circuit échantillonneur bloqueur.

Un tel circuit permet de laisser au courant à mesurer le temps de se stabiliser avant que sa valeur ne soit stockée dans le circuit échantillonneur bloqueur.

Selon un exemple, le circuit 1000 comprend plusieurs circuits inverseurs INV1001, INV1002, INV1003, INV1004, INV1005, INV1006, des transistors M1001, M1002, M1003, M1004, M1005, M1006, et un condensateur C1001. Les transistors M1001, M1002, M1003 et M1005 sont de type PMOS alors que les transistors M1004 et M1006 sont de type NMOS.

Selon un exemple, une borne d'entrée de l'inverseur INV1001 est reliée, de préférence connectée, à un nœud fournissant un signal d'activation EN1000. Une borne de sortie de l'inverseur INV1001 est reliée à une borne d'entrée de l'inverseur INV1002 et à une borne d'entrée de l'inverseur INV1003. Une borne de sortie de l'inverseur INV1002 est reliée, de préférence connectée, à un nœud fournissant un signal d'activation. Une borne de sortie de l'inverseur INV1003 est reliée, de préférence connectée, à une borne de grille du transistor M1003 et à une borne de grille du transistor M1004.

Selon un exemple, une borne de source du transistor M1001 est reliée, de préférence connectée, à un nœud fournissant une tension d'alimentation, et une borne de drain du transistor M1001 est reliée, de préférence connectée, à une borne de source du transistor M1002. Une borne de drain du transistor M1002 est reliée, de préférence connectée, à une borne de source du transistor M1003. Une borne de drain du transistor M1003 est reliée, de préférence connectée, à une borne de drain du transistor M1004. Une borne de drain du transistor M1004 est reliée, de préférence connectée, à un nœud fournissant une tension de référence.

Selon un exemple, une première borne du condensateur C1001 est reliée, de préférence connectée, au nœud milieu entre les transistors M1003 et M1004. Une deuxième borne du condensateur C1001 est reliée, de préférence connectée, au nœud recevant la tension de référence.

Selon un exemple, une borne de source du transistor M1005 est reliée, de préférence connectée, au nœud fournissant la tension d'alimentation, et une borne de drain du transistor M1005 est reliée, de préférence connectée, à la borne de drain du transistor M1006. La borne de source du transistor M1006 est reliée, de préférence connectée, au nœud recevant la tension de référence. Les bornes de grilles des transistors M1005 et M1006 sont reliées, de préférence connectées, entre elles et au nœud milieu entre les transistors M1003 et M1004.

Selon un exemple, une borne d'entrée de l'inverseur INV1005 est reliée, de préférence connectée, au nœud milieu entre les transistors M1005 et M1006. Une borne de sortie de l'inverseur INV1005 est reliée à une borne d'entrée de l'inverseur INV1006. Une borne de sortie de l'inverseur INV1006 est adapté à fournir un signal retardé.

La figure 11 représente, très schématiquement et sous forme de bloc un dispositif électronique 1100 (CPU).

Selon un exemple, le dispositif électronique 1100 est un contrôleur, un microcontrôleur, un processeur ou un microprocesseur.

Ce dispositif 1100 comprend, par exemple, un cœur numérique 1101 (D. Core) adapté à recevoir une tension d'entrée Vcore.

Ce dispositif 1100 comprend, par exemple, une unité de management de puissance 1102 (PMU) comprenant une alimentation à découpage 1103. L'alimentation à découpage 1103 comprend des transistors haut et bas M1101 (NMOS) et M1102 (PMOS). L'alimentation à découpage 1103 est adapté à comprendre un circuit de détection de courant selon un mode de réalisation. Le dispositif 1100 peut compléter l'alimentation à découpage par une bobine L1101 et un condensateur C1101 externes. Selon un exemple, l'alimentation à découpage est de type buck, une alimentation à découpage de type boost, ou une alimentation à découpage de type buck-boost.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Circuit de détection (150 ; 200) d'un courant de sortie d'une alimentation à découpage (100 ; 1103) comprenant un montage échantillonneur bloqueur (SnH151, SnH201) adapté à stocker une image dudit courant de sortie pendant une phase de non conduction d'un interrupteur haute tension (M101) de ladite alimentation à découpage (100 ; 1103).

2. Procédé de détection de courant utilisant un circuit de détection (150 ; 200) d'un courant de sortie d'une alimentation à découpage (100 ; 1103) comprenant un montage échantillonneur bloqueur (SnH151, SnH201) adapté à stocker une image dudit courant de sortie pendant une phase de non conduction d'un interrupteur haute tension (M101) de ladite alimentation à découpage (100 ; 1103).

3. Circuit selon la revendication 1 ou procédé selon la revendication 2, dans lequel ladite image est une image du courant dans les ledit interrupteur.

4. Circuit selon la revendication 1 ou 2, ou procédé selon la revendication 2 ou 3, dans lequel un résultat fourni par ledit montage est comparé à un seuil, de sorte à fournir une information sur un dépassement du seuil.

5. Circuit ou procédé selon la revendication 4, dans lequel ledit seuil est fourni par un courant de référence (Iref150) produit par un convertisseur numérique-analogique.

6. Circuit selon l'une quelconque des revendications 1, 3 à 5, ou procédé selon l'une quelconque des revendications 2 à 5, dans lequel ledit montage échantillonneur bloqueur (SnH151, SnH201) comprend un interrupteur (I201) et un condensateur (C201) .

7. Circuit selon l'une quelconque des revendications 1, 3 à 6, ou procédé selon l'une quelconque des revendications 2 à 6, dans lequel ledit montage échantillonneur bloqueur (SnH151, SnH201) est adapté à être commandé par un signal d'échantillonnage.

8. Circuit selon l'une quelconque des revendications 1, 3 à 7, ou procédé selon l'une quelconque des revendications 2 à 7, dans lequel ledit signal d'échantillonnage déclenche le stockage de ladite image dudit courant de sortie avec un retard temporel.

9. Circuit selon l'une quelconque des revendications 1, 3 à 8, ou procédé selon l'une quelconque des revendications 2 à 8, dans lequel ledit montage échantillonneur bloqueur (SnH151, SnH201) est adapté à recevoir directement ledit courant de sortie.

10. Circuit selon l'une quelconque des revendications 1, 3 à 9, ou procédé selon l'une quelconque des revendications 2 à 9, dans lequel ledit circuit comprend : - une boucle d'asservissement adaptée à recevoir un premier courant à détecter ; et
- un premier transistor (M151) et un deuxième transistors (M152) montés en miroir de courant, ledit premier transistor (M151) étant adapté à recevoir une sortie de ladite boucle d'asservissement, et ledit deuxième transistor (M152) étant adapté à fournir ladite image dudit courant de sortie,
ledit montage échantillonneur bloqueur (SnH151, SnH201) étant disposé entre les bornes de commande des premier et deuxième transistors (M151, M152).

11. Circuit ou procédé selon la revendication 10, dans lequel ladite boucle d'asservissement comprend un comparateur de courant (Comp151) adapté à recevoir une image dudit courant de sortie.

12. Circuit ou procédé selon la revendication 10 ou 11, dans lequel ledit deuxième transistor (M152) est adapté à recevoir, en outre, ledit courant de référence (Iref150).

13. Alimentation à découpage (100 ; 1103) comprenant un circuit de détection de courant selon l'une quelconque des revendications 1, 3 à 12.

14. Alimentation selon la revendication 13, étant une alimentation à découpage de type buck, une alimentation à découpage de type boost, ou une alimentation à découpage de type buck-boost.

15. Dispositif (1100) comprenant une alimentation à découpage (100, 1103) selon la revendication 13 ou 14.

16. Dispositif selon la revendication 15, étant un microcontrôleur.
